Europäisches Patentamt

European Patent Office

Office européen des brevets

(19)

(11) Publication number: **0 132 583**
**B1**

(12) # EUROPEAN PATENT SPECIFICATION

(45) Date of publication of patent specification: **14.09.88**

(51) Int. Cl.⁴: **B 32 B 27/08,** C 09 J 3/14, C 08 L 23/08

(21) Application number: **84106982.6**

(22) Date of filing: **19.06.84**

(54) **Coextrusion of thermoplastic fluoropolymers with thermoplastic polymers.**

(30) Priority: **01.08.83 US 518984**

(43) Date of publication of application:
**13.02.85 Bulletin 85/07**

(45) Publication of the grant of the patent:
**14.09.88 Bulletin 88/37**

(84) Designated Contracting States:
**DE FR GB IT**

(56) References cited:
EP-A-0 079 178
FR-A-2 436 676
US-A-3 549 389

(73) Proprietor: **Ausimont, U.S.A., Inc.**
**44 Whippany Road**
**CN 1838, Morristown, N.J. 07960 (US)**

(72) Inventor: **DeAntonis, Ferdinand Anthony**
**14 Trails End**
**Fogelsville Pennsylvania 18051 (US)**
Inventor: **Murrell, William Henry**
**104 Village Road**
**R.D. 1, Orwigsburg Pennsylvania 17961 (US)**

(74) Representative: **Madgwick, Paul Roland et al**
**Ladas & Parry Isartorplatz 5**
**D-8000 München 2 (DE)**

EP 0 132 583 B1

Courier Press, Leamington Spa, England.

## Description

Background of the invention

The present invention is in the field of thermoplastic coextrusions; more particularly, the invention relates to coextrusions of thermoplastic fluoropolymers with thermoplastic polymers.

It is generally known how to coextrude film and sheet as indicated in the Modern Plastics Encyclopedia, Vol. 56, No. 10A, pp. 131—132, McGraw Hill, October, 1979. Coextruded sheet and film, are made using multimanifold dies such as a multimanifold circular die for blown film or a coextrusion feedback for flat cast film and sheet. The article "Trends & Equipment . . . Coextrusion" by M. H. Naitove in Plastics Technology, February, 1977, pp. 61—71, discusses coextrusion in further detail. For the purposes of this invention the term film includes both film and sheet unless otherwise indicated.

A variety of different thermoplastics have been coextruded to form multilayered coextruded film to take advantage of different properties in different layers. Typical multilayered coextruded film include different thermoplastic polymeric layers having specific characteristics desired in coextruded film. Coextruded films could include a layer of polyethylene or polypropylene to provide a moisture barrier. The coextruded film can incorporate a layer of ionomer or nylon to improve toughness, or a layer of nylon as an oxygen barrier. A layer of polyvinylidene chloride can be included as an oxygen and moisture barrier. A layer of ethylene vinyl acetate copolymer or an ionomer can be included to provide heat sealability to a multilayer coextruded film.

FR—A—2,436,676 discloses a coextruded sheet or film comprising at least one thermoplastic fluoropolymer layer, and at least one thermoplastic polymeric layer bonded to the thermoplastic fluoropolymer layer by an adhesive layer. The fluoropolymer is $PVF_2$, the adhesive is polymethylmethacrylate (PMMA) and the thermoplastic polymeric layer may be ABS copolymer.

Similarly, this document also discloses a process for forming a multilayer sheet or film comprising coextruding at least one thermoplastic fluoropolymer layer, at least one thermoplastic polymeric layer and an intermediate adhesive layer.

Summary of the invention

The present invention provides a coextruded film characterised in that the thermoplastic fluoropolymer is an ethylene/chlorotrifluoroethylene copolymer, an ethylene/tetrafluoroethylene copolymer or a fluorinated ethylene-propylene copolymer; the adhesive is a modified polyolefin copolymer; and the polymer of said thermoplastic polymeric layer is a polyamide or an ethylene/vinyl alcohol copolymer. The coextruded film can be oriented in at least one direction and/or embossed without delamination, fibrillating, or splitting.

Preferably the adhesive is an ethylene/vinyl acetate copolymer; or a blend of a modified polyolefin and an olefin/ester copolymer.

In another aspect the invention provides a process for forming a multilayer film characterised in that the thermoplastic fluoropolymer is an ethylene/chlorotrifluoroethylene copolymer, an ethylene/tetrafluoroethylene copolymer or a fluorinated ethylene-propylene copolymer; the adhesive is a modified polyolefin copolymer; and the polymer of said thermoplastic polymeric layer is a polyamide or an ethylene/vinyl alcohol copolymer. The process can optionally include the steps of orienting and/or embossing the coextruded film.

Preferably the adhesive is an ethylene/vinyl acetate copolymer, or a blend of a modified polyolefin and an olefin/ester copolymer.

Description of the preferred embodiments

The adhesive layer between each thermoplastic fluoropolymer layer and each thermoplastic polymeric layer preferably comprises at least one modified polyolefin. The preferred modified polyolefins are modified ethylene vinyl acetate copolymers. The coextruded film can be oriented in at least one direction and/or embossed.

For the purposes of the present invention coextruded film includes sheets as well as films unless otherwise indicated. The coextrusion is particularly useful as multilayered coextruded film as opposed to thicker sheets. Very thin fluoropolymer layers can be coextruded with thermoplastic polymeric layers to form the multilayered coextruded film of the present invention. A thin layer of the thermoplastic fluoropolymer is often all that is neded to take advantage of the excellent chemical resistance of thermoplastic fluoropolymers while at the same time minimizing the amount of thermoplastic fluoropolymer in the multilayered coextruded film. This is particularly advantageous considering the cost of thermoplastic fluoropolymers in comparison to the general variety of thermoplastic film forming polymer materials available.

The thickness of each layer in the coextruded film is at least $0.13 \times 10^{-2}$ mm (0.05 mils). Each layer can range from $0.13 \times 10^{-2}$ (0.05 mils) to layers as thick as 6.35 mm (250 mils). Film can have layers which are preferably from $0.254 \times 10^{-2}$ to 0.635 mm (0.1 to 25 mils) thick, while sheets can have thicker layers as well as thin layers. The preferred thickness range of the film is from $0.254 \times 10^{-2}$ to 0.635 mm (0.1 mil to 25 mils), preferably $1.27 \times 10^{-2}$ to 0.254 mm (0.5 to 10 mils). The thickness of the adhesive layer is greater than $0.13 \times 10^{-2}$ mm (0.05 mils), and preferably ranges from $0.13 \times 10^{-2}$ mm (0.05 to 0.5 mils), and more preferably $0.254 \times 10^{-2}$ to 0.762 mm (0.1 to 0.3 mils). The multilayer films of the present invention are particularly useful where layer thicknesses are between $0.13 \times 10^{-2}$ to $1.27 \times 10^{-2}$ (0.05 to about 0.5) and preferably $0.13 \times 10^{-2}$ to $0.254 \times 10^{-2}$ mm (0.05 to 0.1 mils). Layers in this range cannot readily be made by other methods to form multilayered films.

The structure of the coextruded film of the present invention can vary. A thermoplastic fluoropolymer layer in the extruded film can vary from 1 to 99% of the thickness of the total structure. Alternately, the thermoplastic polymeric layer can vary from 1 to 99% of the thickness of the total structure. There should be a sufficient amount of the adhesive to prevent delamination.

The multilayered coextruded film of the present invention can have a variety of structures so long as there is an adhesive layer between each thermoplastic fluoropolymer layer and each thermoplastic polymeric layer. A typical film structure includes a thermoplastic polymeric layer, an adhesive layer and a thermoplastic fluoropolymer layer. Another structure envisioned includes a layer of thermoplastic fluoropolymer, an adhesive layer, a thermoplastic polymeric layer, an adhesive layer, and another thermoplastic fluoropolymer layer. Any variation of the order of the layers of the thermoplastic fluoropolymer and thermoplastic polymeric layer can be made. The number of layers in the multilayered coextruded film is only limited by the equipment.

The multilayer coextruded film of the present invention can be coextruded using coextrusion equipment generally known in the art. This includes coextrusion using a feed block with a standard die, a multimanifold circular die for blown bubble film, and multimanifold die for flat cast film and sheet. A coextrusion feed-block and flat die can be used for cast film. Useful equipment is described in the article by Naitove referenced in the Background of the Invention and hereby incorporated by reference. The coextrusion process has advantages over other processes to form multilayered films. These advantages include the combination of molten layers in one step. Coextrusion allows a broad range of layer thickness variation, particularly at very thin ranges.

Thermoplastic fluoropolymers useful in the present invention are film-forming thermoplastic fluoropolymers. The thermoplastic fluoropolymers include ethylene chlorotrifluoroethylene copolymer, ethylene tetrafluoroethylene copolymer, and fluorinated ethylene-propylene copolymer (FEP). Particularly preferred is ethylene chlorotrifluoroethylene copolymer.

Useful thermoplastic polymers include film-forming thermoplastic polymers. Such polymers include polyamides, and ethylene/vinyl alcohol copolymers.

Preferred polyamides include polyepsilon-caprolactam and polyhexamethyleneadipamide. Other useful polyamides include film-forming polyamides made from the polymerization of lactam monomers, and the copolymerization of diamines and dicarboxylic acids.

The adhesive layer can be made of an extrudable adhesive which is compatible for coextrusion with the adjacent polymer layers.

The most preferred modified polyolefin is the modified copolymer of ethylene and vinyl acetate. This copolymer is modified to contain carboxylic acid groups. This copolymer has been found to be particularly useful to form coextruded laminates of thermoplastic fluoropolymers and polyamides.

Preferred adhesives are CXA type resins solid by the Du Pont Company. These resins have been indicated to be useful for coextrusion of a vareity of polymeric materials not including fluoropolymers. These resins have been found to be useful in the process of the present invention to make the multilayered coextruded film of the present invention. CXA 3101, CXA 1124, and CXA 1123 are particularly preferred. A detailed description of these CXA resins is found in the following bulletins hereby incorporated by reference: "Du Pont CXA, Coextrudable Adhesive Resins For Multilayer Packaging Structures" by Philip S. Blatz; "Du Pont CXA 3101, Coextrudable Adhesive Resin For Flexible Packaging"; and "Du Pont CXA 1123 & 1124". Elvax® EVA 3135X Ethylene Vinyl Acetate Copolymer Resin For Flexible Packaging describes a resin useful to vary the viscosity of the resin selected for use as the adhesive layer. Resins such as CXA 3101 and CXA 1124 have been found to be satisfactory for coextrusion to form films having layers of fluoropolymers at temperatures above the recommended adhesive processing temperature limit of 230°C to 240°C (446°F to 464°F).

The adhesive layer can be a blend of at least two modified polyolefins. Preferred modified polyolefins are modified ethylene vinyl acetate copolymers, which are modified to have acid groups in addition to ester groups. A preferred blend comprises a first modified ethylene vinyl acetate copolymer having a melt index of about 0.1 to 10 grams per 10 minutes, and a second modified ethylene vinyl acetate copolymer having a melt index of from 5 and preferably 10 to 200 grams per 10 minutes. For the purposes of the present invention, melt index is measured according to ASTM Test No. D-1238. The blend of the first and second polyolefin should comprise from 25 to 99%, preferably 50 to 95% and more preferably 75 to 95% of the first polyolefin based on the blend of the first polyolefin and the second polyolefin. Correspondingly there is 1 to 75%, preferably 5 to 50% and more preferably 5 to 25% of the second polyolefin.

The most preferred modified ethylene vinyl acetate copolymer for use as the first polymer is CXA-3101 produced by Du Pont and has a melt index of 3.5 (ASTM D-1238), a density of 0.948 grams per cubic centimeter (ASTM D-792), and the softening point of 55°C (131°F) (ASTM D-1525). The most preferred second modified ethylene vinyl acetate copolymer in an adhesive blend is CXA-1124 produced by Du Pont and has a melt index of 25 grams per 10 minutes, a density of 0.950 grams per cubic centimeter (ASTM D-792), and a softening point of 38°C (101°F) (ASTM D-1525). The most preferred adhesive composition is a blend of 90% by weight CXA-3101 and 10% by weight CXA-1124.

Other useful adhesives include modified and unmodified ethylene methylacrylate copolymer and adhesives disclosed in U.S. Patent Nos. 4,058,647 and 4,254,169 hereby incorporated by reference.

The multilayer coextruded film of the present invention includes a coextrusion of the fluoropolymer and an adhesive layer adjacent to at least one side of the fluoropolymer layer.

In order to successfully coextrude the multilayered film of the present invention, the thermoplastic fluoropolymer layer, the adhesive layer, and the thermoplastic layer must be made of polymeric materials which are compatible in the coextrusion process. Compatibility can be indicated by melt properties which are similar as to allow coextrusion. Melt properties of interest include melting points, melt indexes, apparent viscosity and melt stability. Non-compatibility of polymers in the coextrusion can result in the inability to form the film where adjacent layers have good adhesion and uniform thickness across the film width. Non-compatible polymers can result in streaky, mottled film. Typically, non-compatible extrudable polymers designed to form a clear multilayer film result in a mottled, cloudy film or poor polymer distribution. The compatibility of the various polymers from the above lists for use in the film laminates of the present invention can be determined by considering the above indicators of compatibility. Once the polymers having the desired properties are selected, experimental trials can be conducted to determine the optimum combination of relative properties in adjacent layers.

The polymers to be coextruded must not only be compatible, but they must be compatible within a relatively close temperature range so that they can be coextruded through a common die. It has been found that a limitation with modified ethylene vinyl acetate copolymer adhesives is their temperature stability. The highest temperature at which the materials (such as CXA 3101) can be extruded is between about 232°C and 243°C (450°F and 470°F). Generally, for fluoropolymers such as ethylene chlorotrifluoroethylene, the lowest processing temperatures is higher than the adhesive temperature range. A preferred set of processing melt temperatures for ethylene chlorotrifluoroethylene copolymer is 260°C to 277°C (500°F to 530°F). Preferred processing melt temperature for polymers to be coextruded to the ethylene chlorotrifluoroethylene is 232°C to 271°C (450°F to 520°F). For polyepsiloncaprolactam the lowest preferred range is 243°C to 271°C (470°F to 520°F) and for ethylene vinyl alcohol copolymer the preferred range is 232°C to 243°C (450°F to 470°F). The melt temperature can be adjusted within the limits to vary the melt viscosity to improve coextrusion compatibility.

The coextruded multilayer film of the present invention can be oriented and/or embossed. The multilayer film can be oriented without delaminating or fibrillating. The embossing and or orientation of the film can be conducted by methods known in the art. A typical process and range of conditions for monoaxially orienting a fluoropolymer and polyamide film laminate are similar to those disclosed for polyamides in U.S. Patent No. 4,362,585, hereby incoroporated by reference. Alternately, the film laminate of the present invention can be biaxially oriented using a blown tube apparatus, or a tenter frame apparatus.

The film can be monoaxially drawn or biaxially drawn as required and considering the draw limitation of the polymers in the various layers. Typically, film can be monoaxially drawn to a draw ratio of from 1.5:1 to 10:1 and preferably from 1.5:1 to 6:1. Typically, film can be biaxially drawn to a draw ratio of from 1.5:1 to 10:1 and preferably 1.5:1 to 6:1 in the machine direction and from 1.5:1 to 10:1 and preferably 1.5:1 to 6:1 in the transverse direction. Draw ratio is an indication of the increase in the dimension in the direction of draw.

The film laminate of the present invention can be embossed by means known in the art if it is nonoriented or oriented. Typically, embossing can be accomplished using film embossing rolls.

It has been found that the multilayered coextruded film of the present invention does not delaminate whether or not it is oriented and/or embossed. Further upon orientation the multilayer film does not fibrillate.

The fluoropolymer layers of the coextruded films of the present invention have chemical inertness and allow the film to be used as cable wrap, in drug packaging applications, and as carrier films in process such as in framing copper clad laminates of electronic uses.

Several examples are set forth below to illustrate the nature of the invention and the manner of carrying it out. However, the invention should not be considered as being limited to the details thereof. All parts are by weight or otherwise indicated.

Example 1

A thermoplastic layer of polyepsiloncaprolactam having specific gravity of 1.13 (ASTM D-792) and a melting point of 420°F (250°C) was cast coextruded with an equimolar ethylene chlorotrifluoroethylene copolymer (ECTFE) having a specific gravity of 1.68. The polyepsiloncaprolactam is sold by Allied Corporation as Capron® 8207F nylon (nylon 6). The relative formic acid viscosity was 73 measured in 90 percent formic acid at a concentration of 9.2 percent by weight. The ethylene chlorotrifluoroethylene (ECTFE) copolymer is sold by Allied Corporation as Halar® 500. The ECTFE copolymer had a density of 1.68 gm/ml, and a melt index of 15 g/10 minutes as measured according to ASTM 1238 run at 135°C (275°F) under a piston load of 2160 grams, and about 49 to 51 mol percent ethylene and a corresponding amount of chlorotrifluoroethylene monomer. The adhesive utilized was a blend of modified ethylene vinyl acetate copolymers. The blend comprised 10% of CXA-1124 and 90% of CXA-3101, both sold by the Du Pont Co.

The polyepsiloncaprolactam was extruded through a 6.35 cm (2-1/2 inch) diameter Davis Standard Extruder having the temperature profile of Zone 1—210°C (410°F), Zone 2—232°C (450°F, Zone 3—271°C (520°F), Zone 4—254°C (490°F), Zone 5—254°C (490°F), and adaptor Zone 1—254°C (490°F). The extruder was operated at a screw speed of 35 RPM with a barrel pressure of 6,895 kPa (1000 psig). The motor drive load was 36 amps. The melt temperature was 263°C (505°F).

The ethylene chlorotrifluoroethylene copolymer was extruded through a 4.45 cm (1-3/4 inch) (nominal) diameter Reifenhauser extruder. The extruder had a temperature profile which included Zone 1—232°C (450°F), Zone 2—271°C (520°F), Zone 3—282°C (540°F), Zone 4—274°C (525°F), and the adaptor Zone at 254°C (490°F). This extruder was operated at a screw speed of 29 RPM with a barrel pressure of 4,482 kPa (650 psig). The motor drive load was 8.5 amps. The melt temperature was 272°C (522°F).

The adhesive blend was extruded through a 3.81 cm (1-1/2 inch) diameter Davis Standard Extruder. The temperature profile in this extruder was Zone 1—138°C (280°F), Zone 2—232°C (450°F), and adaptor Zone 1 at 228°C (443°F). This extruder had a screw speed of 20 RPM, a barrel pressure of 4,482 kPa (650 psig). The melt temperature was 224°C (435°F). The motor drive load was 2.5 amps.

The extrudate from the three extruders was passed through a coextrusion feedblock manufactured by the Johnson Plastic Corporation and operating at an adaptor temperature at Zone 1—248°C (478°F) and Zone 2—249°C (481°F). The laminate from the coextrusion adaptor when to a die having three Zones operating at about 263°C (505°F).

The coextruded film was then cast on a roll at 82°C (180°F), followed by a cooling roll at 63°C (145°F), and a roll at 79°C (175°F).

The film made had a total thickness of $5.84 \times 10^{-2}$ mm (2.30 mils) with the following layers: $0.99 \times 10^{-2}$ (1.36 mils) of polyepsiloncaprolactam (nylon 6), 0.39 mils of adhesive blend, $3.9 \times 10^{-2}$ mm (1.55 mils) of ethylene chlorotrifluoroethylene copolymer (ECTFE). The adhesion between the layers of ECTFE copolymer and nylon was tested according to ASTM Test No. ASTM F88. The adhesion and value was 305 g/cm (775 g/in). The multilayer film was clear, had a uniform appearance, and uniform polymer distribution in each layer.

## Example 2

A five layer laminate was coextruded using the ECTFE copolymers and nylon 6 of Example 1. The adhesive utilized was a modified ethylene vinyl acetate copolymer, CXA-3101.

The polyepsiloncaprolactam was extruded through the Davis Standard Extruder having the temperature profile of Zone 1—210°C (410°F), Zone 2—232°C (450°F), Zone 3—260°C (500°F), Zone—254°C (490°F), Zone 5—254°C (490°F), and adaptor Zone 1—254°C (490°F). The extruder was operated at a screw speed of 16 RPM with a barrel pressure of 6,895 kPa (1000 psig) and a motor drive load amperage of 45 amps. The melt temperature was 237°C (458°F).

The ethylene chlorotrifluoroethylene copolymer was extruded through a 4.445 cm (1-3/4 inch) (nominal) diameter Reifenhauser extruder. The extruder had a temperature profile which included Zone 1—232°C (450°F), Zone 2—277°C (530°F), Zone 3—285°C (545°F), Zone 4—288°C (550°F), and the adaptor Zone at 500°F. This extruder was operated at a screw speed of 40 RPM with a barrel pressure of 4,619 kPa (670 psig) and a motor drive load amperage of 115 amps. The melt temperature was 262°C (504°F).

The adhesive was extruded through a 3.81 cm (1-1/2 inch) diameter Davis Standard Extruder. The temperature profile in this extruder was Zone 1—121°C (250°F), Zone 2—246°C (475°F), and adaptor Zone 1 at 238°C (460°F). This extruder had a screw speed of 62 RPM and a motor drive load of 2.8 amps. The melt temperature was 202°C (396°F).

The extrudate from the three extruders was passed through a coextrusion feedblock manufactured by the Johnson Plastic Corporation and operating at an adaptor temperature at Zone 1—249°C (480°F) and Zone 2—249°C (481°F). The laminate from the coextrusion adaptor went to a die having three Zones operating at Zone 1—265°C (509°F), Zone 2—263°C (506°F), and Zone 3—263°C (506°F).

The coextruded film was then cast on a roll at 79°C (175°F), followed by a cooling roll at 88°C (190°F), and a roll at 110°C (230°F).

The film had a total thickness of $2.54 \times 10^{-2}$ mm $2.54 \times 10^{-2}$ mm (1.0 mils) with the following layers: $0.254 \times 10^{-2}$ mm (0.1 mil) ECTFE copolymer/$0.203 \times 10^{-2}$ (0.08 mil) CXA 3101/$1.63 \times 10^{-2}$ mm (0.64 mil) nylon 6/$0.203 \times 10^{-2}$ (0.08 mil) CXA 3101/$0.254 \times 10^{-2}$ (0.1 mil) ECTFE copolymer. The adhesion between the layers and ECTFE copolymer and nylon was tested as in Example 1. The ECTFE layer, which was only $0.254 \times 10^{-2}$ mm (0.1 mils), broke before delamination occurred. The multilayer film was clear, had a uniform appearance, and a uniform polymer distribution in each layer.

## Example 3

A five layer film was coextruded having layers of ethylene vinyl alcohol copolymer and ECTFE copolymer of the type described in Example 1. The adhesive was the same type as described in Example 2.

A thermoplastic layer of ethylene vinyl alcohol copolymer produced by Kuraray of Japan (Grade EP-f) was cast coextruded with layers of equimolar ethylene chlorotrifluoroethylene copolymer. The ethylene vinyl alcohol copolymer had a melt index of 1.6 grams per 10 minutes as measured on the ASTM D-1238 test at a load of 2160 grams at 190°C. The ethylene vinyl alcohol resin con-

tained about 60 mole percent vinyl alcohol and had a glass transition temperature of 69°C.

The ethylene vinyl alcohol was extruded through a 6.35 (2-1/2 inch) diameter Davis Standard Extruder having the temperature profile of Zone 1—143°C (290°F), Zone 2—193°C (380°F), Zone 3—227°C (440°F), Zone 4—227°C (440°F), Zone 5—210°C (410°F), and adaptor Zone 1—246°C (475°F). The extruder was operated at a screw speed of 19 RPM with a barrel pressure of 3,447 kPa 500 psig and a motor drive load of 38 amps. The melt temperature was (407°F).

The ethylene chlorotrifluoroethylene copolymer was extruded through a 4.445 cm (1-3/4 inch) (nominal) diameter Reifenhauser extruder. The extruder had a temperature profile which included Zone 1—232°C (450°F), Zone 2—277°C (530°F), Zone 3—285°C (545°F), Zone 4—288°C (550°F), and the adaptor Zone at 260°C (500°F). The motor drive load was 11 amps. This extruder was operated at a screw speed of 42 RPM with a barrel pressure of 4,826 kPa (700 psig). The melt temperature was 266°C (510°F).

The adhesive was extruded through a 3.81 cm (1-1/2 inch) diameter Davis Standard Extruder. The temperature profile in this extruder was Zone 1—121°C (250°F), Zone 2—246°C (475°F), and adaptor Zone 1 at 238°C (460°F). This extruder had a screw speed of 20 RPM, and a motor drive amperage of 2.6 amps. The melt temperature was 224°C (435°F).

The extrudate from the three extruders was passed through a coextrusion feedblock coextruder adaptor manufactured by the Johnson Plastic Corporation and operating at an adaptor temperature at Zone 1—249°C (480°F) and Zone 2—249°C (481°F). The laminate from the coextrusion adaptor when to a die having three Zones operating at Zone 1—265°C (509°F), Zone 2—263°C (506°F), Zone 3—263°C (506°F).

The coextruded film was then cast on a roll at 79°C (175°F), followed by a cooling roll at 85°C (185°F), and a roll at 110°C (230°F).

The film had a total thickness of $2.54 \times 10^{-2}$ (1.0 mils) with the following layers: $0.254 \times 10^{-2}$ mm (0.1 mil) ECTFE copolymer/$0.203 \times 10^{-2}$ mm (0.64 mil) ethylene vinyl alcohol copolymer/$0.203 \times 10^{-2}$ mm (0.08 mil) CXA 3101/$1.63 \times 10^{-2}$ mm (0.64 mil) ethylene vinyl alcohol copolymer/$0.203 \times 10^{-2}$ mm (0.08 mil) CXA 3101/$0.254 \times 10^{-2}$ mm (0.1 mil) ECTFE copolymer. The adhesion between the layers of ECTFE copolymer and ethylene vinyl alcohol copolymer was tested as in Example 1. The ECTFE layer, which was only $0.254 \times 10^{-2}$ mm (0.1 mil) thick broke before delamination occurred. The multilayer film was clear, had a uniform appearance, and a uniform polymer distribution in each layer.

Example 4

A thermoplastic oriented coextruded multilayered film of polyepsiloncaprolactam and an equimolar ethylene chlorotrifluoroethylene copolymer of the type used in Example 1 was made. The adhesive utilized was a CXA 3101 modified ethylene vinyl acetate copolymer as described above.

The polyepsiloncaprolactam was extruded through a 6.35 cm (2-1/2 inch) diameter Davis Standard Extruder having the temperature profile of Zone 1—210°C (410°F), Zone 2—232°C (450°F), Zone 3—271°C (520°F), Zone 4—260°C (500°F), Zone 5—254°C (490°F), and adaptor Zone 1—258°C (496°F). The extruder was operated at a screw speed of 30 RPM with a barrel pressure of 7,584 kPa (1100 psig) and a motor drive amperage of 41 amps. The melt temperature was 252°C (486°F).

The ethylene chlorotrifluoroethylene copolymer was extruded through a 4.445 cm (1-3/4 inch) (nominal) diameter Reifenhauser extruder. The extruder had a temperature profile which included Zone 1—227°C (440°F), Zone 2—252°C (485°F), Zone 3—279°C (535°F), Zone 4—274°C (525°F), and the adaptor Zone at 260°C (500°F). This extruder was operated at a screw speed of 33 RPM; the motor drive amperage was 10 amps. The melt temperature was 270°C (518°F).

The adhesive was extruded through a 3.81 cm (1-1/2 inch) diameter Davis Standard Extruder. The temperature profile in this extruder was Zone 1—138°C (280°F), Zone 2—232°C (450°F), and adaptor Zone 1 at 225°C (437°F). This extruder had a screw speed of 33 RPM. The motor drive load was 2.6 amps. The melt temperature was 221°C (429°F).

The extrudate from the three extruders was passed through a coextrusion feedblock manufactured by the Johnson Plastic Corporation which was operated at an adaptor temperature at Zone 1—252°C (485°F) and Zone 2—252°C (485°F). The laminate from the coextrusion feedblock went to a die having three Zones operating at Zone 1—264°C (508°F), Zone 2—264°C (507°F) and Zone 3—262°C (503°F).

The coextruded film was then cast on a roll at 82°C (180°F), followed by a cooling roll at 63°C (145°F), and a roll of 77°C (170°F).

The film was oriented monoaxially. It travelled over a preheated roll at 116°C (240°F), to a slow stretch roll at 113°C (235°F), to a fast stretch roll at 103°C (235°F), to a heat set roll at 121°C (250°F), and finally to a cooling roll at 93°C (200°F). The draw ratio was 3.2:1. A detailed description of the orientation process is discussed in U.S. Patent No. 4,362,585.

The final structure of the film laminate was $0.56 \times 10^{-2}$ mm (0.22 mils) ECTFE copolymer/$0.30 \times 10^{-2}$ mm (0.12 mil) CXA 3101 copolymer/$1.68 \times 10^{-2}$ mm (0.66 mils) nylon 6. The adhesion between the layers of ECTFE copolymer and nylon was tested as in Example 1 after orientation. The adhesion value was $2.56 \times 10^{-2}$ g/cm (650 g/in). The oriented multilayer film was clear, had a uniform appearance and uniform polymer distribution in each layer.

While exemplary embodiments of the invention have been described, the true scope of the invention is to be determined from the following claims.

## Claims

1. A coextruded sheet or film comprising at least one thermoplastic fluoropolymer, and at least one thermoplastic polymeric layer bonded to the thermoplastic fluoropolymer layer by an adhesive layer, characterised in that the thermoplastic fluoropolymer is an ethylene/chlorotrifluoroethylene copolymer, an ethylene/tetrafluoroethylene copolymer or a fluorinated ethylene-propylene copolymer; the adhesive is a modified polyolefin copolymer; and the polymer of said thermoplastic polymeric layer is a polyamide or an ethylene/vinyl alcohol copolymer.

2. A sheet or film as claimed in claim 1 wherein said adhesive is an ethylene/vinyl acetate copolymer, or a blend of a modified polyolefin and an olefin/ester copolymer.

3. A sheet or film as claimed in claim 1 wherein the adhesive layer comprises a blend of a first modified ethylene/vinyl acetate copolymer having a melt index of from 0.1 to 10 g/10 minutes and a second modified ethylene/vinyl acetate copolymer having a melt index from 5 to 1000 g/10 minutes.

4. A sheet or film as claimed in any preceding claim wherein the film is oriented in at least one direction.

5. A sheet or film as claimed in any preceding claim wherein the film is embossed.

6. A sheet or film as claimed in any preceding claim wherein the thicknesses of said layers are between $0.13 \times 10^{-2}$ mm and 6.35 mm (0.05 mil to 250 mils).

7. A sheet or film as claimed in claim 1 wherein the adhesive layer comprises a mixture of modified polyolefin copolymers.

8. A sheet or film as claimed in claim 7 wherein said mixture comprises at least two modified ethylene/vinyl acetate copolymers.

9. A sheet or film as claimed in claim 4 which is monoaxially oriented.

10. A sheet or film as claimed in claim 4 which is biaxially oriented.

11. A sheet or film as claimed in any preceding claim wherein the thermoplastic polymeric layer is composed of polyamide, polyethylene, polypropylene, polyolefin copolymer, an ionomer, polystyrene, polycarbonate, acrylic polymer or copolymer, or a fluoropolymer.

12. A process for forming a multilayer sheet or film comprising coextruding at least one thermoplastic fluoropolymer layer, at least one thermoplastic polymeric layer and an intermediate adhesive layer characterised in that the thermoplastic fluoropolymer is an ethylene/chlorotrifluoroethylene copolymer, an ethylene/tetrafluoroethylene copolymer or a fluorinated ethylene-propylene copolymer; the adhesive is a modified polyolefin copolymer; and the polymer of said thermoplastic polymeric layer is a polyamide or an ethylene/vinyl alcohol copolymer.

13. A process as claimed in claim 12 wherein said adhesive is an ethylene/vinyl acetate copolymer, or a blend of a modified polyolefin and an olefin/ester copolymer.

14. A process as claimed in claim 12 or claim 13 wherein said fluoropolymer layer is coextruded at a temperature of 260°C to 277°C (500°F to 530°F) and said polymeric layer is extruded at a temperature of 232°C to 271°C (450°F to 520°F).

15. A process as claimed in any of claims 12 to 14 wherein said sheet or film is embossed.

16. A process as claimed in any of claims 12 to 15 wherein said sheet or film is oriented.

17. A process as claimed in any of claims 12 to 16 wherein the thicknesses of said layers are between $0.13 \times 10^{-2}$ mm and 6.35 mm (0.05 mil to 250 mils).

18. A process as claimed in claim 12 wherein the thermoplastic polymer is polyepsiloncaprolactam, the thermoplastic fluoropolymer is ethylene chlorotrifluoroethylene and the adhesive is a modified ethylene/vinyl acetate copolymer.

19. A process as claimed in claim 12 wherein the thermoplastic polymer is ethylene vinyl alcohol, the fluoropolymer is ethylene chlorotrifluoroethylene, and the adhesive is a modified ethylene/vinyl acetate copolymer.

## Patentansprüche

1. Koextrudiertes Blatt- oder Feinfolienmaterial mit mindestens einer thermoplastischen Fluorpolymerschicht und mindestens einer thermoplastischen Polymerschicht, die mit der thermoplastischen Fluorpolymerschicht durch eine Klebstoffschicht verbunden ist, dadurch gekennzeichnet, daß das thermoplastische Fluorpolymer ein Ethylen/Chlortrifluorethylen-Copolymer, ein Ethylen/Tetrafluorethylen-Copolymer oder ein fluoriertes Ethylen/Propylen-Copolymer ist, daß der Klebstoff ein modifiziertes Polyolefincopolymer ist und daß das Polymer der thermoplastischen Polymerschicht ein Polyamid oder ein Ethylen/Vinylalkohol-Copolymer ist.

2. Blatt- oder Feinfolienmaterial nach Anspruch 1, dadurch gekennzeichnet, daß der Klebstoff ein Ethylen/Vinylacetat-Copolymer oder ein Gemisch aus einem modifizierten Polyolefin und einem Olefin/Ester-Copolymer ist.

3. Blatt- oder Feinfolienmaterial nach Anspruch 1, dadurch gekennzeichnet, daß die Klebstoffschicht mindestens teilweise aus einem Gemisch aus einem ersten modifizierten Ethylen/Vinylacetat-Copolymer mit einem Schmelzindex von 0,1 bis 10 g/10 min und einem zweiten modifizierten Ethylen/Vinylacetat-Copolymer mit einem Schmelzindex von 5 bis 1000 g/10 min besteht.

4. Blatt- oder Feinfolienmaterial nach einem der vorhergehenden Ansprüche, dadurch gekennzeichnet, daß der Film in mindestens einer Richtung orientiert ist.

5. Blatt- oder Feinfolienmaterial nach einem der vorhergehenden Ansprüche, dadurch gekennzeichnet, daß die Feinfolie geprägt ist.

6. Blatt- oder Feinfolienmaterial nach einem der vorhergehenden Ansprüche, dadurch gekennzeichnet, daß die Dicken der genannten Schichten zwischen $0,13 \times 10^{-2}$ mm und 6,35 mm betragen.

7. Blatt- oder Feinfolienmaterial nach Anspruch 1, dadurch gekennzeichnet, daß die Klebstoffschicht mindestens teilweise aus einem Gemisch aus modifizierten Polyolefincopolymeren besteht.

8. Blatt- oder Feinfolienmaterial nach Anspruch 7, dadurch gekennzeichnet, daß das Gemisch mindestens zwei modifizierte Ethylen/Vinylacetat-Copolymere enthält.

9. Blatt- oder Feinfolienmaterial nach Anspruch 4, das uniaxial orientiert ist.

10. Blatt- oder Feinfolienmaterial nach Anspruch 4, das biaxial orientiert ist.

11. Blatt- oder Feinfolienmaterial nach einem der vorhergehenden Ansprüche, dadurch gekennzeichnet, daß die thermoplastische Polymerschicht aus Polyamid, Polyethylen, Polypropylen, Polyolefincopolymer, einem Ionomer, Polystyrol, Polycarbonat, Acrylpolymer oder -copolymer oder einem Fluorpolymer besteht.

12. Verfahren zum Herstellen eines mehrschichtigen Blatt- oder Feinfolienmaterials, in dem mindestens eine thermoplastische Fluorpolymerschicht, mindestens eine thermoplastische Polymerschicht und eine Klebstoff-Zwischenschicht koextrudiert werden, dadurch gekennzeichnet, daß das thermoplastische Fluorpolymer ein Ethylen/Chlortrifluorethylen-Copolymer, ein Ethylen/Tetrafluorethylen-Copolymer oder ein fluoriertes Ethylen/Propylen-Copolymer ist, daß der Klebstoff ein modifiziertes Polyolefincopolymer ist und daß das Polymer der thermoplastischen Polymerschicht ein Polyamid oder ein Ethylen/Vinylalkohol-Copolymer ist.

13. Verfahren nach Anspruch 12, dadurch gekennzeichnet, daß der Klebstoff ein Ethylen/Vinylacetat-Copolymer oder ein Gemsich aus einem modifizierten Polyolefin und einem Olefin/Ester-Copolymer ist.

14. Verfahren nach Anspruch 12 oder 13, dadurch gekennzeichnet, daß die Fluorpolymerschicht bei einer Temperatur von 260 bis 22°C koextrudiert und die Polymerschicht bei einer Temperatur von 232 bis 271°C extrudiert wird.

15. Verfahren nach einem der Ansprüche 12 bis 14, dadurch gekennzeichnet, daß das Blatt- oder Feinfolienmaterial geprägt ist.

16. Verfahren nach einem der Ansprüche 12 bis 15, dadurch gekennzeichnet, daß das Blatt- oder Feinfolienmaterial orientiert ist.

17. Verfahren nach einem der Ansprüche 12 bis 16, dadurch gekennzeichnet, daß die Dicken der genannten Schichten zwische $0,13 \times 10^{-2}$ mm und 6,35 mm betragen.

18. Verfahren nach Anspruch 12, dadurch gekennzeichnet, daß das thermoplastische Polymer Polyepsiloncaprolactam, das thermoplastische Fluorpolymer Ethylenchlortrifluorethylen und der Klebstoff modifiziertes Ethylen/Vinylacetat-Copolymer ist.

19. Verfahren nach Anspruch 12, dadurch gekennzeichnet, daß das thermoplastische Polymer Ethylenvinylalkohol, das Fluorpolymer Ethylenchlortrifluorethylen und der Klebstoff ein modifiziertes Ethylen/Vinylacetat-Copolymer ist.

## Revendications

1. Une feuille ou un film coextrudé comprenant au moins une couche de polymère fluoré thermoplastique, et au moins une couche de polymère thermoplastique liée à la couche de polymère fluoré thermoplastique par une couche d'adhésif, caractérisé en ce que le polymère fluoré thermoplastique est un copolymère d'éthylène/chlorotrifluoroéthylène, un copolymère d'éthylène/tétrafluoroéthylène ou un copolymère de propylène-éthylène fluoré; l'adhésif est un copolymère de polyoléfine modifiée; et le polymère de ladite couche de polymère thermoplastique est un polyamide ou un copolymère d'éthylène/alcool vinylique.

2. Une feuille ou un film selon la revendication 1 selon lequel ledit adhésif est un copolymère d'éthylène/acétate de vinyle, ou un mélange d'une polyoléfine modifiée et d'un copolymère d'oléfine/ester.

3. Une feuille ou un film selon la revendication 1 selon lequel la couche d'adhésif comprend un mélange d'un premier copolymère modifié d'éthylène-acétate de vinyle ayant un indice de fusion de 0,1 à 10 g/10 min et un second copolymère modifié d'éthylène-acétate de vinyle ayant un indice de fusion de 5 à 1 000 g/10 min.

4. Une feuille ou un film selon l'une quelconque des revendications précédentes selon lequel le film est orienté dans au moins une direction.

5. Une feuille ou un film selon l'une quelconque des revendications précédentes selon lequel le film est gaufré.

6. Une feuille ou un film selon l'une quelconque des revendications précédentes selon lequel les épaisseurs desdites couches sont comprises entre $0,13 \times 10^{-2}$ mm et 6,35 mm.

7. Une feuille ou un film selon la revendication 1 selon lequel la couche d'adhésif comprend un mélange de copolymères de polyoléfine modifiée.

8. Une feuille ou un film selon la revendication 7 selon lequel ledit mélange comprend au moins deux copolymères modifiés d'éthylène/acétate de vinyle.

9. Une feuille ou un film selon la revendication 4 qui est orienté monoaxialement.

10. Une feuille ou un film selon la revendication 4 qui est orienté biaxialement.

11. Une feuille ou un film selon l'une quelconque des revendications précédentes selon lequel la couche de polymère thermoplastique est composée de polyamide, de polyéthylène, de polypropylène, de copolymère de polyoléfine, d'un ionomère, de polystyrène, du polycarbonate, de polymère ou de copolymère acrylique ou d'un composé fluoré.

12. Un procédé pour former une feuille ou un film à couches multiples comprenant la coextrusion d'au moins une couche de polymère fluoré thermoplastique, d'au moins une couche de polymère thermoplastique et d'une couche d'adhésif intermédiaire caractérisé en ce que le polymère fluoré thermoplastique est un copolymère d'éthy- lène/chlorotrifluoroéthylène, un copolymère d'éthylène/tétrafluoroéthylène ou un copolymère de propylène-éthylène fluoré; l'adhésif est un copolymère de polyoléfine modifiée; et le polymère de ladite couche de polymère thermoplastique est un polyamide ou un polymère d'éthylène/alcool vinylique.

13. Un procédé selon la revendication 12 selon lequel ledit adhésif est un copolymère d'éthylène/acétate de vinyle ou un mélange de polyoléfine modifiée et d'un copolymère d'oléfine/ester.

14. Un procédé selon la revendication 12 ou 13 selon lequel ladite couche de polymère fluoré est coextrudée à une température de 260°C à 277°C (500°F à 530°F) et ladite couche de polymère est extrudée à une température de 232°C à 271°C (450°F à 520°F).

15. Un procédé selon l'une des revendications 12 à 14 selon lequel ladite feuille ou ledit film est gaufré.

16. Un procédé selon l'une des revendications 12 à 15 selon lequel ladite feuille ou ledit film est orienté.

17. Un procédé selon l'une des revendications 12 à 16 selon lequel les épaisseurs desdites couches sont comprises entre $0,13 \times 10^{-2}$ mm et 6,35 mm.

18. Un procédé selon la revendication 12 selon lequel le polymère thermoplastique est le polyepsiloncaprolactame, le polymère fluoré thermoplastique est un copolymère d'éthylène-chlorotrifluoroéthylène et l'adhésif est un copolymère modifié d'éthylèneacétate de vinyle.

19. Un procédé selon la revendication 12 selon lequel le polymère thermoplastique est un copolymère d'éthylène-alcool vinylique, le polymère fluoré est un copolymère d'éthylène-chlorotrifluoroéthylène et l'adhésif est un copolymère modifié d'éthylèneacétate de vinyle.